(19) Europäisches Patentamt
European Patent Office
Office européen des brevets

(11) **EP 2 379 767 B1**

(12) **EUROPÄISCHE PATENTSCHRIFT**

(45) Veröffentlichungstag und Bekanntmachung des Hinweises auf die Patenterteilung:
**10.06.2020 Patentblatt 2020/24**

(21) Anmeldenummer: **09776466.6**

(22) Anmeldetag: **24.03.2009**

(51) Int Cl.:
**C23C 14/08** (2006.01)  **C23C 14/35** (2006.01)

(86) Internationale Anmeldenummer:
**PCT/EP2009/002138**

(87) Internationale Veröffentlichungsnummer:
**WO 2010/049012 (06.05.2010 Gazette 2010/18)**

(54) **HAFNIUM- ODER ZIRKONIUMOXID-BESCHICHTUNG**

HAFNIUM OXIDE OR ZIRCONIUM OXIDE COATING

REVÊTEMENT D'OXYDE D'HAFNIUM OU DE ZIRCONIUM

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **31.10.2008 PCT/EP2008/009206**

(43) Veröffentlichungstag der Anmeldung:
**26.10.2011 Patentblatt 2011/43**

(73) Patentinhaber: **Bühler Alzenau GmbH**
**63755 Alzenau (DE)**

(72) Erfinder: **SCHERER, Michael**
**63796 Kahl (DE)**

(74) Vertreter: **Vossius & Partner**
**Patentanwälte Rechtsanwälte mbB**
**Siebertstrasse 4**
**81675 München (DE)**

(56) Entgegenhaltungen:
EP-A- 1 408 541      WO-A- 94/03331
DE-T2- 68 928 474    US-A1- 2002 093 732
US-A1- 2003 207 549  US-A1- 2007 095 650
US-A1- 2007 252 232  US-B1- 6 413 386

• TOKAS R B ET AL: "A comparative morphological study of electron beam co-deposited binary optical thin films of HfO2:SiO2 and ZrO2:SiO2" CURRENT APPLIED PHYSICS, NORTH-HOLLAND, Bd. 8, Nr. 5, 1. August 2008 (2008-08-01), Seiten 589-602, XP022688874 ISSN: 1567-1739 [gefunden am 2007-11-01]

**Beschreibung**

Die Erfindung betrifft optische Bauteile mit einer Beschichtung aus hafnium- oder zirkoniumhaltigem Oxid sowie Verfahren zur Herstellung optischer Bauteile nach den Oberbegriffen der unabhängigen Ansprüche.

Die Verwendung von Hafniumoxid oder Zirkoniumoxid als Beschichtungswerkstoff für optische Elemente ist bekannt. Hafniumoxid zeichnet sich bspw. gegenüber anderen Beschichtungswerkstoffen durch einen hohen Brechungsindex im sichtbaren Spektralbereich (n = 2,08 bei $\lambda$ = 550 nm) und im UV-Bereich (n = 2,35 bei $\lambda$ = 250 nm) sowie eine hohe Transparenz sowohl im sichtbaren als auch im UV-Bereich aus (Absorptionskante bei $\lambda$ = 220 nm). Hafniumoxid eignet sich daher insbesondere zur Anwendung als Beschichtungswerkstoff für optische Komponenten mit geringem Reflektionsgrad und hoher Durchlässigkeit sowie für Spiegel, beispielsweise für Laserspiegel. Analoges gilt für Zirkoniumoxid.

Es ist bekannt, Hafniumoxid- und Zirkoniumoxidbeschichtungen mit Hilfe des Ion Beam Sputtering herzustellen. Mit diesem Verfahren können qualitativ hochwertige Beschichtungen mit geringer Absorption und Streuung erzeugt werden, allerdings erfolgt die Abscheidung nur mit vergleichsweise geringen Aufwachsraten von < 0.1 nm/s. Außerdem weisen die mit Hilfe des Ion Beam Sputterings abgeschiedenen Beschichtungen hohe innere Spannungen (> 1000 MPa) auf. Weiterhin ist es bekannt, Hafniumoxid- und Zirkonoxidschichten durch Magnetronsputtern abzuscheiden. Dieses Verfahren ermöglicht zwar hohe Aufwachsraten von > 0.4 nm/s, die erzeugten Schichten zeigen jedoch nur eine mäßige Qualität in Bezug auf Absorption und Streuung und weisen außerdem hohe innere Spannungen zwischen 1000 und 2000 MPa auf.

Beide Verfahren liefern somit Schichten mit hohen inneren Spannungen. Die durch solch hohe innere Spannungen hervorgerufenen Kräfte können - je nach Substratwerkstoff - zu Verformungen der Substratoberflächen und somit zu einer Beeinträchtigung der optischen Eigenschaften der beschichteten optischen Elemente führen. Weiterhin können hohe innere Spannungen Schichtablösungen mit oder ohne Beschädigung des Substratmaterials zur Folge haben.

Aus der DE 689 28 474 T2 ist ein amorpher Oxidfilm bekannt, der Silizium und mindestens ein Mitglied aus der Gruppe Zr, Ti, Hf, Sn, Ta und In enthält. Ein solcher Oxidfilm soll eine ausgezeichnete Kratzbeständigkeit, Abriebsbeständigkeit und chemische Haltbarkeit aufweisen. Als solcher wird er auf Gegenstände aufgebracht, bei denen eine hohe Haltbarkeit erforderlich ist, beispielsweise als Schutzschicht auf ein Wärmestrahlung abschirmendes Glas. Weiterhin kann er als Diffusionssperre in einem laminierten Glas verwendet werden. Die in der DE 689 28 474 T2 beschriebenen Anwendungen beziehen sich somit auf Schichten, die eine hohe Durchlässigkeit im sichtbaren Bereich haben sollen; Eigenschaften im UV-Bereich werden in dieser Schrift nicht angesprochen.

Aus der US 6 413 386 B1 ist bereits eine hafnium- oder zirkoniumhaltige Beschichtung bekannt, mit einem Siliziumanteil zwischen 6at% und 10at% und einem O-Anteil zwischen 65 und 68at%.

Der Erfindung liegt die Aufgabe zugrunde, eine optische Beschichtung bereitzustellen, die in einem Spektralbereich, der vom Sichtbaren bis hin zum nahen UV-Bereich (d.h. bis zu einer Wellenlänge von 230 nm) reicht, einen möglichst hohen Brechungsindex sowie gute optische Eigenschaften (insbesondere. geringe Absorption und Streuung) und möglichst geringe innere Spannungen aufweist. Weiterhin liegt der Erfindung die Aufgabe zugrunde, solche Beschichtungen sowie optische Bauteile mit einer solchen Beschichtung zur Verfügung zu stellen und ein Verfahren zu ihrer Herstellung vorzuschlagen.

Die Aufgabe wird durch die Merkmale der unabhängigen Ansprüche gelöst. Vorteilhafte Ausgestaltungen sind Gegenstand der Unteransprüche.

Im Folgenden wird lediglich auf die erfindungsgemäße Beschichtung mit Hafniumoxid und einer Beimischung von Silizium ($Hf_xSi_yO_z$) eingegangen. Für die Beschichtungen mit Zirkoniumoxid und einer Beimischung von Silizium ($Zr_xSi_yO_z$) gilt das Gesagte analog, soweit nicht anderes angegeben ist.

Danach besteht die Beschichtung aus Hafniumoxid mit einer Beimischung von Silizium in einer Menge von 1 at-% bis 3 at-%, wobei at-% einen Anteil einer Menge eines Elements in Atomprozent der Gesamtmenge bezeichnet. Hafniumoxid verfügt im sichtbaren bis hin zum nahen UV Spektralbereich über einen hohen Brechungsindex von n > 2. Die Beimischung von Silizium in dem beanspruchten Mengenbereich reduziert den Brechungsindex, weswegen sie auf diese geringe Menge reduziert sein sollte.

Überraschenderweise zeigt sich jedoch, dass diese geringe Beimischung von Silizium in dem beanspruchten Mengenbereich bereits ausreicht, um die inneren Spannungen der Beschichtung erheblich zu reduzieren.

Die Beschichtung weist einen O-Anteil (z) auf, der zwischen 65 at-% und 68 at-% liegt und so dass diese Beschichtung nur geringe optische Verluste bis in den UV-Bereich hinein aufweist.

Bevorzugt weist die erfindungsgemäße Beschichtung einen inneren Schichtstress (Druckspannung) zwischen 100 MPa und 800 MPa auf, wobei vorzugsweise der Brechungsindex größer 1,9 beträgt bei einer Wellenlänge von 550nm und/oder die Extinktion einen Wert $\kappa$ kleiner $3*10^{-3}$ bei einer Wellenlänge von 242nm aufweist, wobei vorzugsweise der Si-Gehalt zwischen 1at% und 10at% beträgt. Vorzugsweise beträgt der innere Schichtstress weniger als 300

MPa.

Die Extinktion $\kappa$ ist hierbei über die folgenden Zusammenhänge $\kappa$ gegeben, wobei A den Absorptionsgrad, T den Transmissionsgrad und R den Reflexionsgrad bezeichnet.

Die erfindungsgemäße $Hf_xSi_yO_z$-Beschichtung wird mittels Sputtern, insbesondere DC - oder Mittelfrequenz -Magnetronsputtern, hergestellt. Durch Einstellung der Prozessparameter können hohe Sputterraten erreicht werden, und über den Siliziumgehalt können die inneren Spannungen der aufgesputterten Schicht deutlich gegenüber denen von reinem Hafniumoxid reduziert werden. Vorteilhafterweise erfolgt die Herstellung der $Hf_xSi_yO_z$-Schicht durch reaktives Co-Magnetronsputtern von Hf- und Si-Targets; alternativ können zum Co-Sputtern Targets aus HfSi oder $Hf_xSi_yO_z$ und Si verwendet werden. Weiterhin kann die $Hf_xSi_yO_z$-Schicht durch reaktives Magnetronsputtern eines Verbindungstargets erzeugt werden, das Hf und Si in geeigneter Zusammensetzung enthält. Auch eine Schichtherstellung mittels teilreaktiven Magnetronsputterns unter Verwendung eines leitfähigen $Hf_xSi_yO_z$-Verbindungstargets ist denkbar. Besonders vorteilhaft ist es, wenn das reaktive oder teilreaktive Mittelfrequenz - Magnetronsputtern mit einer reaktiven In-Situ-Plasmabehandlung, wie sie in der PCT/EP 2003/013649 beschrieben ist, und die durch Bezugnahme in diese Anmeldung aufgenommen wird, kombiniert wird. Das in der PCT/EP 2003/013649 beschriebene Verfahren ermöglicht insbesondere die Abscheidung von Schichten mit einem O-Anteil (z) der zwischen 65 at-% und 68 at-% liegt und die daher nur geringe optische Verluste bis in den UV-Bereich hinein aufweisen.

Die erfindungsgemäße Beschichtung kann als in amorpher, mikro- oder nanokristalliner Form oder einer Mischform zwischen den genannten Formen vorliegen.

Die erfindungsgemäße Beschichtung eignet sich insbesondere zur Verwendung in Mehrschichtsystemen in denen mindestens Hafnium-Oxid vorkommt, beispielsweise für Laserspiegel, Kantenfilter sowie für UV durchlässige oder reflektierende Filter, insbesondere für einen Spektralbereich bis zu einer Untergrenze von 220nm.

Im Folgenden wird die Erfindung anhand eines in den Figuren dargestellten Ausführungsbeispiels näher erläutert. Dabei zeigen:

Fig. 1a  eine schematische Darstellung eines Substrats mit einer $Hf_xSi_yO_z$-Beschichtung;

Fig. 1b  eine schematische Darstellung eines Substrats mit einem Mehrschichtsystem;

Fig. 2a  eine Darstellung der Transmission von unbeschichteten und mit $HfO_2$ - Schichten beschichteten Quarzsubstraten im Spektralbereich von 200nm bis 600 nm;

Fig. 2b  eine Darstellung der Transmission einer $Hf_{30,8}Si_{2,5}O_{66,7}$-Schicht und mehrerer $HfO_2$-Schichten auf einem Quarzsubstrat im Spektralbereich von 220 nm bis 260 nm.

Fig. 3  Messwerte des Brechungsindex n bei 550 nm und der inneren Spannungen einer $Hf_xSi_yO_{66,7}$ Schicht in Abhängigkeit des Siliziumgehalts y;

Fig. 4  Messwerte des Brechungsindex n bei 550 nm und der Aufwachsraten beim reaktiven Magnetronsputtern von $Hf_xSi_yO_{66,7}$ Schichten in Abhängigkeit des Leistungsverhältnis PHf/(PHf+PSi);

Fig. 5  Messwerte des Brechungsindex n bei 550 nm, der Extinktion bei 242nm und der normierten inneren Spannungen von $Hf_xSi_yO_{66,7}$ Schichten in Abhängigkeit des Siliziumgehalts y;

Fig. 6  Messwerte der Extinktion bei 242 nm und der Absorptionskante von $Hf_xSi_yO_{66,7}$ Schichten in Abhängigkeit des Siliziumgehalts y;

Fig. 7  eine graphische Darstellung des Zusammenhangs zwischen dem Siliziumgehalt y der $Hf_xSi_yO_z$-Schicht und dem entsprechenden Siliziumgehalt eines HfSi-Mischtargets, und

Fig. 8  Messwerte des Brechungsindex n und der Extinktion k einer $Zr_xSi_yO_{66,66}$-Schicht und einer $ZrO_2$-Schicht in Abhängigkeit von der Wellenlänge.

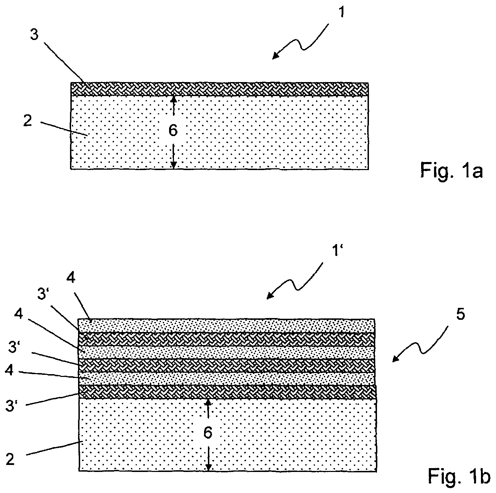

Figur 1a zeigt einen Ausschnitt eines optischen Bauteils 1 mit einem Substrat 2, auf das eine erfindungsgemäße Beschichtung 3 aus $Hf_xSi_yO_z$ aufgebracht ist. Die Dicke der Beschichtung 3 ist dabei gegenüber der Dicke 6 des Substrats 2 stark überhöht dargestellt. Das Substrat 2 besteht aus einem Quarzglas oder einem Kunststoff. Das Bauteil 1 ist ein Filter, das in einem vorgegebenen Spektralbereich eine möglichst geringe Absorption aufweisen soll. Der hier betrachtete Spektralbereich reicht von sichtbarem Licht bis hin zu UV-Strahlung mit einer Wellenlänge von etwa 230 nm.

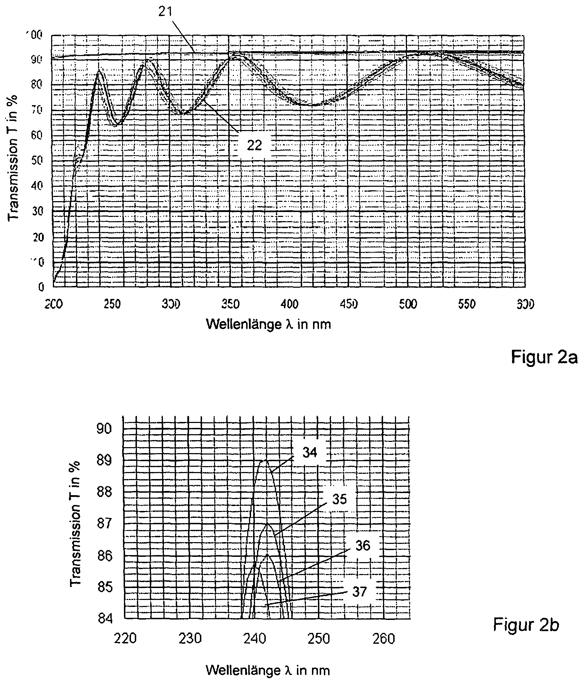

Es ist bekannt, dass Einzelschichten oder Mehrschichtsysteme auf Basis von Hafniumdioxid ($HfO_2$) für solche Applikationen besonders gut geeignet sind, da dieser Werkstoff in einem Spektralbereich vom Sichtbaren hin zu 220nm eine geringe Absorption aufweist. Figur 2a zeigt eine grafische Darstellung der Transmission von unbeschichteten und mit $HfO_2$ - Schichten beschichteten Quarzsubstrate, die durch reaktives Magnetronsputtern mit unterschiedlichen Prozessparametern (Druck, Plasmaenergie, ...) auf das Substrat 2 aufgetragen wurden. Die unbeschichteten Quarzsubstrate zeigen im gesamten betrachteten Spektralbereich eine Transmission von > 90% (Kurven 21), Die mit $HfO_2$-Schichten beschichteten Quarzsubstrate zeigen im betrachteten Spektralbereich eine mäßige Absorption mit einer Absorptionskante (T= 50%) von ca. 220nm (Kurven 22).

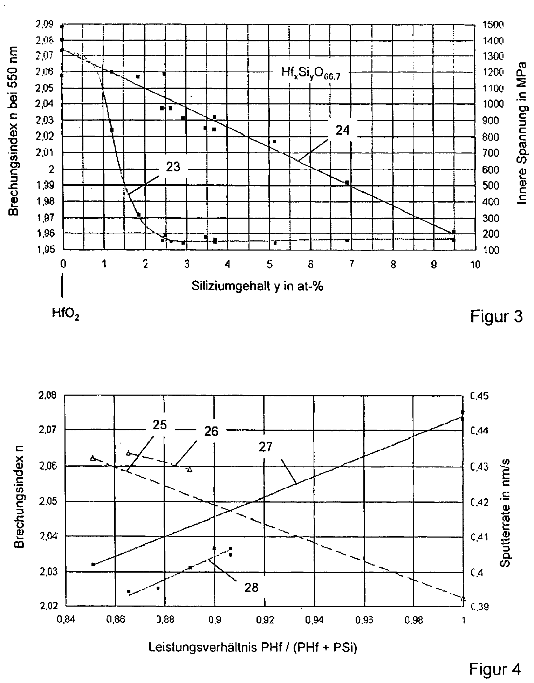

Allerdings ist die innere Spannung einer $HfO_2$-Beschichtung 3 mit 1000 MPa - 1500 MPa sehr hoch: Wie Figur 3 zeigt, werden in einer Beschichtung aus reinem $HfO_2$ innere Spannungen von 1300 - 1400 MPa gemessen. Solch hohe innere Spannungen der Beschichtung 3 üben große Kräfte auf das darunter liegende Substrat 2 aus, was zu Verformungen des Substrats 2 und/oder Schichtablösung führen kann.

Die inneren Spannungen der Beschichtung 3 können reduziert werden, wenn das Hafnium der $HfO_2$-Beschichtung zu einem Teil durch Silizium ersetzt wird: Wie aus den Messwerten und der Ausgleichskurve 23 in Figur 3 ersichtlich ist, beträgt die innere Spannung einer $Hf_xSi_yO_{66,7}$-Beschichtung 3 bei einem Silizium-Anteil von $y \approx 1,5$ at% lediglich etwa 500 MPa, bei einem Silizium-Anteil von $y \approx 2,5$ at% ist die innere Spannung sogar auf unter 200 MPa abgesunken.

Die Messungen der inneren Spannungen (Stress $\sigma_{film}$) der Beschichtung 3 erfolgte mit einem Messsystem SIG-500SP der Firma sigma-physik (D-37115 Duderstadt) unter Verwendung der Stoney-Formel (1909)

$$\sigma_{film} = \frac{(x_{after} - x_{before})}{12\,L\,a} \cdot \frac{E_{substrate}}{1 - \nu_{substrate}} \cdot \frac{d^2_{substrate}}{d_{film}}$$

| Esubstrate | Young's modulus Substrat |
| --- | --- |
| vsubstrate | Poisson Ratio Substrat |
| dsubstrate | Substratdicke |
| dfilm | Schichtdicke |
| L | Abstand Schicht -Detektor |
| a | Abstand Laserstrahlen |

Als Substratmaterial wurden einseitig polierte monokristalline Silizium Wafer von 3" Durchmesser und $380\mu m$ Dicke verwendet. Diese Wafer eignen sich wegen der sehr geringen Rautiefe von 0,1 nm und der sehr homogenen Oberfläche besonders gut für die Stressmessung. Zunächst wurden unbeschichtete Wafer vermessen. Dazu wird der Wafer auf den Probenhalter in genau definierter Ausrichtung aufgelegt und 5 mal nacheinander der Abstand von beiden Laserstrahlen auf einem Detektor (Xbefore) gemessen und unter der Probennummer abgespeichert. Die einzelnen vorvermessenen Silizium Wafer wurden dann mit HfxSiyOz Schichten unterschiedlicher Zusammensetzung beschichtet. Die Schichtdicke wurde zu ca. 250nm gewählt, um die Messgenauigkeit zu erhöhen. Die genauen Schichtdicken wurden mit einem spektralen Ellipsometer bestimmt. Danach wurden die einzelnen beschichteten Wafer in der gleichen Ausrichtung auf den Probenhalter aufgelegt und jeweils 5 mal nacheinander der Abstand der beiden Laserstrahlen auf dem Detektor (Xafter) gemessen und auch unter der entsprechenden Probennummer abgespeichert. Mit der Stoney - Formel wurde aus beiden Messungen der Stress der einzelnen Beschichtungen bestimmt.

Die Erzeugung solcher $Hf_xSi_yO_{66,7}$-Beschichtungen 3 kann insbesondere durch reaktives Co-Magnetronsputtern von Hf- und Si-Targets erfolgen, wobei bei geeigneter Wahl der Prozessparameter hohe Sputterraten erreicht werden können: Aus Figur 4 ist ersichtlich, dass sich die Beimischung von Silizium sogar positiv auf die Aufwachsrate auswirkt; Kurven 25 und 26 stellen Aufwachsraten bei Verwendung unterschiedlicher Sputterparameter dar.

Durch ein teilweises Ersetzen des Hf durch Si in $Hf_xSi_yO_{66,7}$ können also - bei hohen Sputterraten - die inneren Spannungen der Beschichtung 3 reduziert werden. Allerdings nimmt mit wachsendem Silizium-Anteil y der Brechungs-index n der $Hf_xSi_yO_{66,7}$-Beschichtung 3 ab (siehe Ausgleichsgerade 24 in Figur 3 und Ausgleichsgeraden 27, 28 in Figur 4, die den Brechungsindex n als Funktion des Si-Gehalts y bei einer Wellenlänge $\lambda = 550$ nm zeigen). Daher sollte zur Erzielung eines hohen Brechungsindex der Silizium-Anteil y möglichst gering sein. Diese gegenläufigen Anforderungen können befriedigt werden, wenn der Silizium-Anteil y zwischen 1 at-% und 10 at-% eingestellt wird.

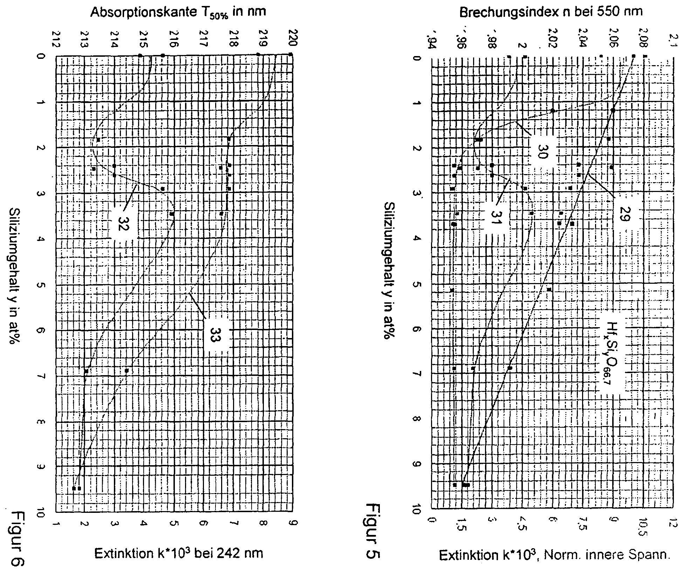

Ein besonders günstiger Si-Konzentrationsbereich liegt zwischen etwa y = 1,5 at-% und y = 3 at-% (siehe Figur 5). Wie aus dem Verlauf der Ausgleichsgerade 29 der Messwerte des Brechungsindex n bei 550 nm zu erkennen ist, ist in diesem Si-Konzentrationsbereich der Brechungsindex n mit etwa 2,05 vergleichsweise groß. Gleichzeitig sind die inneren Spannungen (Ausgleichskurve 30 in Figur 5 bzw. Ausgleichskurve 23 in Figur 3) in diesem Si-Konzentrationsbereich bereits auf Werte unterhalb von 500 MPa abgefallen. Weiterhin sind in diesem Si-Konzentrationsbereich auch die optischen Eigenschaften der $Hf_xSi_yO_{66,7}$-Beschichtung 3 besonders günstig, da dort, gemessen bei einer UV-Wellenlänge von 242 nm, ein lokales Minimum der Extinktion vorliegt (Ausgleichskurve 31 in Figur 5 und Ausgleichskurve 32 in Figur 6). Eine entsprechende Abhängigkeit der Extinktion von der Si-Konzentration findet man bei Wellenlängen bis zur entsprechenden Absorptionskante.

In dem Si-Konzentrationsbereich 1,5 at% < y < 3 at% ist weiterhin die Absorptionskante nahezu konstant und nur unwesentlich gegenüber der Absorptionskante von reinen $HfO_2$ (d.h. y = 0) verschoben (siehe Ausgleichskurve 33 in Figur 6); das deutet darauf hin, dass die Schichtstruktur im Si-Konzentrationsbereich 1,5 at% < y < 3 at% $HfO_2$-dominiert

ist. Wie die Detailansicht von Figur 2b zeigt, erhöht ein Co-Sputtern von Silizium auch die Transmission der $Hf_xSi_yO_{66,7}$-Schicht: Im abgebildeten Spektralbereich ist die gemessene Transmission einer Probe mit einem Silizium-Gehalt von y = 2,5 at-% (Kurve 34) höher als die mit unterschiedlichen Prozessparametern dargestellten Schichten aus reinem $HfO_2$ (Kurven 35 - 37).

Mit einer Zunahme der Si-Konzentration (y > 5 at%) bildet sich mehr und mehr ein $HfO_2$-$SiO_2$-Mischoxid aus, mit deutlicher Verschiebung der Absorptionskante in den kurzwelligen Spektralbereich (Ausgleichskurve 33 in Figur 6), mit abnehmender Extinktion bei 242 nm (Ausgleichskurven 31 bzw. 32 in Figur 5 bzw. Figur 6) sowie einer stetigen Abnahme des Brechungsindex n (Ausgleichsgerade 29 in Figur 5).

Die erfindungsgemäße Beschichtung 3 wird durch reaktives Co-Magnetronsputtern von Hf- und Si-Targets hergestellt. Weiterhin können beim reaktiven Co-Magnetronsputtern auch Targets aus HfSi oder aus $Hf_xSi_yO_z$ und Si verwendet werden. Die $Hf_xSi_yO_{66,7}$-Beschichtung 3 kann auch durch andere Verfahren erzeugt werden, beispielsweise durch Verwendung von HfSi-Verbindungstargets geeigneter Zusammensetzung. Weiterhin kann die Schicht durch teilreaktives Magnetronsputtern von einem DC-leitfähigen $Hf_xSi_yO_z$ Target hergestellt werden. Schließlich kann eine Schichtherstellung durch eines der erwähnten Verfahren mit einer reaktiven in-situ Plasmabehandlung kombiniert werden.

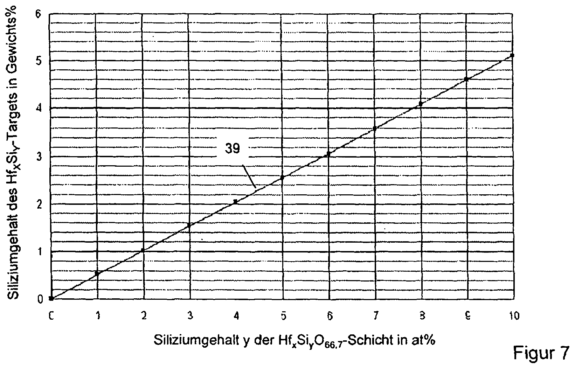

Besonders vorteilhaft ist die Verwendung von HfSi- oder $Hf_xSi_yO_z$-Verbindungstargets, deren Si-Gehalt in einer solchen Weise eingestellt ist, dass die gesputterte Schicht eine minimale Extinktion bei gleichzeitig geringer innerer Spannung und hohem Brechungsindex aufweist. Mit solchen Targets können durch Co-Magnetronsputtern mit Si verschiedene Anforderungen optimiert werden mit dem Vorteil geringer innerer Spannungen der an der HfSi- oder $Hf_x$-$Si_yO_z$-Kathodenumgebung aufwachsenden Schicht, was die Wahrscheinlichkeit einer Partikelbelastung deutlich herabsetzt. Figur 7 zeigt den Zusammenhang zwischen dem Siliziumgehalt y der $Hf_xSi_yO_z$-Schicht in at-% und dem entsprechenden Siliziumgehalt eines HfSi-Mischtargets in Gewichts-% (Gerade 39). Für den oben beschriebenen bevorzugten Si-Gehalt y der $HfSi_yO_{66,7}$-Schicht (1 at-% < y < 10 at-%) sollte bei Verwendung eines HfSi-Verbindungstargets das Target also einen Siliziumgehalt zwischen 0,5 Gew.-% und 5 Gew.-% haben. Für einen bevorzugten Si-Gehalt y der $Hf_xSi_yO_{66,7}$Schicht (1 at-% < y < 7 at-%) sollte bei Verwendung eines HfSi-Verbindungstargets das Target einen Siliziumgehalt zwischen 0,5 Gew.-% und 4 Gew.-% haben.

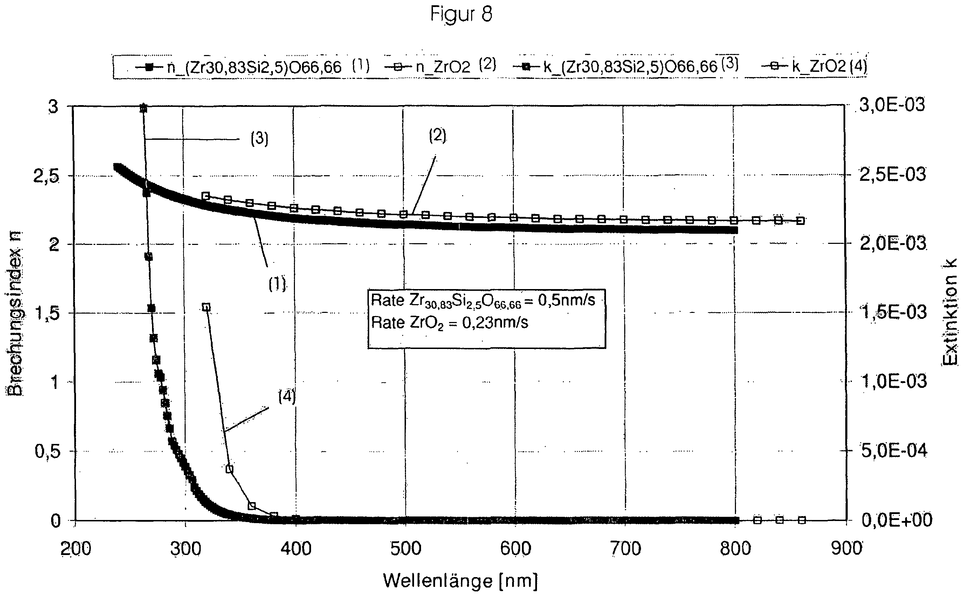

Fig. 8 zeigt Messwerte des Brechungsindex n und der Extinktion k einer $Zr_xSi_yO_{66,66}$-Schicht und einer $ZrO_2$-Schicht in Abhängigkeit von der Wellenlänge. Wie daraus zu erkennen ist die Reduzierung der optischen Verluste im UV-Bereich bei $Zr_xSi_yO_z$ noch ausgeprägter als bei $Hf_xSi_yO_z$, d.h., bei reinem $ZrO_2$ erreicht die Extinktion schon bei einer Wellenlänge von 330 nm einen Wert von 1E-3, wohingegen bei $Ht_{30,83}Si_{2,5}O_{66,6}$ dieser Wert erst bei 280 nm erreicht wird. Bei dieser Zusammensetzung kann mit einer hohen Rate von ca. 0,5 nm/s beschichtet werden, wohingegen bei einer Beschichtung mit $ZrO_2$ nur maximal die halbe Rate erzielt wurde. Wie bei $Hf_xSi_yO_{66,7}$ verringert sich auch bei der entsprechenden Zirkoniumverbindung der Stress um etwa den gleichen Faktor gegenüber dem reinen Metalloxid.

Bevorzugt wird eine Schicht mit stöchiometrischer oder nahezu stöchiometrischer Zusammensetzung ($Zr_{30,83}Si_{2,6}O_{66,66}$) hergestellt oder verwendet, die optimale optische und mechanische Eigenschaften, d.h., geringe optische Verluste bis in den UV-Spektralbereich, hohen Brechwert > 2,1 und geringen Stress < 100 MPa bietet.

Figur 1b zeigt ein optisches Bauteil 1', ein Kantenfilter, das zur Erhöhung seiner Lichtdurchlässigkeit mit einer integrierten Reflektionsminderungsschicht bzw. Antireflexschicht versehen ist. Kantenfilter lassen Licht bis zu einer Grenzfrequenz fast ungefiltert durch, blocken aber ab der Grenzfrequenz ein Großteil des Lichtes. Als Beschichtung wird ein Mehrschichtsystem 5 mit mehreren übereinanderliegenden Schichten 3', 4 aus dielektrischen Werkstoffen mit unterschiedlichen Brechungsindizes verwendet, bei dem Schichten 3' aus einem hochbrechenden Werkstoff und Schichten 4 aus einem relativ dazu niedrigbrechenden Material abwechselnd übereinander angeordnet sind. Das Mehrschichtsystem besteht typischerweise aus 10 - 100 Einzelschichten 3', 4, wobei die Einzelschichten 3', 4 typischerweise eine Dicke von 20 - 100 nm haben. Im vorliegenden Ausführungsbeispiel besteht das Substrat 2 aus einer dünnen Platte aus Quarz oder einem Kunststoff. Die Dicke 6 des Substrats beträgt zwischen 0,5 und 1,0 mm; in Figur 1b ist die Dicke des Mehrschichtsystems 5 also gegenüber der Dicke 6 des Substrats 2 stark überhöht dargestellt. Die Schichten 3', 4 des Mehrschichtsystems 5 werden durch ein Sputterverfahren auf das Substrat 2 aufgebracht und üben - je nach Größe der inneren Spannungen in den Einzelschichten - Kräfte auf das Substrat 2 aus. Die Kräfte der Einzelschichten addieren sich, so dass bei einem komplexen Mehrschichtsystem 5 mit inneren Spannungen von > 1 GPa sehr hohe Kräfte auf das Substrat 2 wirken können. Um eine Verformung des Substrats 2 aufgrund solcher Schichtspannungen zu vermeiden, müssen daher die inneren Spannungen der Einzelschichten 3', 4 möglichst gering sein. Dies wird im vorliegenden Ausführungsbeispiel dadurch erreicht, dass die Schichten 3' mit hohem Brechungsindex aus $Hf_xSi_yO_{66,7}$ bestehen, wobei der Silizium-Gehalt y vorzugsweise zwischen 1,5 at% und 3 at% liegt. Bei entsprechender Einstellung der Sputterparameter weisen solche Sputterschichten - wie oben beschrieben - eine geringe innere Spannung bei hohem Brechungsindex und hoher Transparenz auf. Die Einzelschichten 4 mit geringem Brechungsindex können beispielsweise aus $SiO_2$ bestehen, das einen Brechungsindex von ca. n = 1,48 bei 550nm aufweist.

Die erfindungsgemäßen $Hf_xSi_yO_z$- und $Zr_xSi_yO_z$-Beschichtungen eignen sich insbesondere zur Verwendung in laserbeständigen optischen Komponenten mit geringer Restreflektion und hoher Durchlässigkeit für UV-Licht aus einem Wellenlängenbereich bis zu 230 nm, beispielsweise für optische Komponenten, die in Laseroptiken in Mikrolithographiesystemen zur Herstellung mikroelektronischer Komponenten eingesetzt werden (z.B. zur Verwendung in Laseroptiken für KrF-Excimerlaser mit einer Arbeitswellenlänge von $\lambda\square= 248$ nm). Die erfindungsgemäßen $Hf_xSi_yO_z$- und $Zr_xSi_yO_z$-Beschichtungen eignen sich weiterhin zur Anwendung in Spiegeln, insbesondere Laserspiegeln, und Kantenfiltern, weiterhin für Interferenzfilter bis in den UV-Bereich. Insbesondere kann die Beschichtung als Antireflektionsbeschichtung auf Halbleiterlasern, verwendet werden.

**Patentansprüche**

1. Optisches Bauteil (1) mit einem Substrat (2) und einer auf das Substrat (2) aufgebrachten Beschichtung (3) aus einem hafnium- oder zirkoniumhaltigen Oxid ($Hf_xSi_yO_z$ bzw. $Zr_xSi_yO_z$), wobei das hafnium- oder zirkoniumhaltige Oxid ($Hf_xSi_yO_z$ bzw. $Zr_xSi_yO_z$) eine Beimischung eines Silizium-Anteils (y) zwischen 1 at-% und 3 at-%, und einen O-Anteil (z) zwischen 65 at-% und 68 at-% enthält, wobei das Substrat (2) aus Quarz besteht.

2. Optisches Bauteil (1') nach Anspruch 1, wobei die Beschichtung als Mehrschichtsystem (5) ausgebildet ist, welches mindestens eine Schicht (3') aus einem hafnium- oder zirkoniumhaltigen Oxid ($Hf_xSi_yO_z$ bzw. $Zr_xSi_yO_z$) umfasst, wobei das hafnium- oder zirkoniumhaltige Oxid ($Hf_xSi_yO_z$ bzw. $Zr_xSi_yO_z$) eine Beimischung eines Silizium-Anteils (y) zwischen 1 at-% und 3 at-%, und einen O-Anteil (z) zwischen 65 at-% und 68 at-% enthält.

3. Optisches Bauteil (1, 1') nach einem der vorhergehenden Ansprüche, **dadurch gekennzeichnet, dass** der Schichtstress der Schicht (3) oder des Mehrschichtsystems geringer als 800 MPa, vorzugsweise geringer als 300 MPa oder geringer als 100 MPa ist.

4. Verfahren zur Herstellung eines optischen Bauteils (1, 1') nach einem der Ansprüche 1 bis 3, wobei die Beschichtung (3) aus dem hafnium- oder zirkoniumhaltigen Oxid mit Hilfe von Magnetronsputtern auf das Substrat (2) aufgetragen wird, wobei die Beschichtung (3, 3') eine Zusammensetzung $Hf_xSi_yO_z$ oder $Zr_xSi_yO_z$ mit einer Beimischung eines Silizium-Anteils (y) zwischen 1 at-% und 3 at-%, und einen O-Anteil (z) zwischen 65 at-% und 68 at-% enthält.

5. Verfahren nach Anspruch 4, **dadurch gekennzeichnet, dass** die Herstellung mittels reaktivem Co-Magnetronsputtern von Hf oder Zr und Si erfolgt.

6. Verfahren nach einem der Ansprüche 4 oder 5, **dadurch gekennzeichnet, dass** der Si-Anteil in einer solchen Weise eingestellt wird, dass die Schicht (3) eine minimale Extinktion bei gleichzeitig geringem Schichtstress und hohem Brechungsindex aufweist.

7. Verwendung eines optischen Bauteils (1) nach einem der Ansprüche 1 bis 3, **dadurch gekennzeichnet, dass** das optische Bauteil (1) als Laserspiegel verwendet wird.

8. Verwendung eines optischen Bauteils (1) nach einem der Ansprüche 1 bis 3, **dadurch gekennzeichnet, dass** das optische Bauteil (1) als Kantenfilter verwendet wird.

**Claims**

1. An optical component (1) comprising a substrate (2) and a coating (3) of a hafnium- or zirconium-containing oxide ($Hf_xSi_yO_z$ or $Zr_xSi_yO_z$) which is applied to the substrate (2), wherein the hafnium- or zirconium-containing oxide ($Hf_xSi_yO_z$) or ($Zr_xSi_yO_z$) comprises an admixture of a silicon content (y) between 1 at.% and 3 at.% and an O content (z) between 65 at.% and 68 at.%, wherein the substrate (2) consists of quartz.

2. The optical component (1') according to claim 1, wherein the coating is formed as a multi-layer system (5) which comprises at least one layer (3') of a hafnium- or zirconium-containing oxide ($Hf_xSi_yO_z$ or $Zr_xSi_yO_z$), wherein the hafnium- or zirconium-containing oxide ($Hf_xSi_yO_z$ or $Zr_xSi_yO_z$) comprises an admixture of a silicon content (y) between 1 at.% and 3 at.% and an O content (z) between 65 at.% and 68 at.%.

3. The optical component (1, 1') according to any one of the preceding claims, **characterized in that** the layer stress of the layer (3) or of the multi-layer system is lower than 800 MPa, preferably lower than 300 MPa or lower than 100 MPa.

**4.** A method of producing an optical component (1, 1') according to any one of claims 1 to 3, wherein the coating (3) of the hafnium- or zirconium-containing oxide is applied to the substrate (2) by means of magnetron sputtering, wherein the coating (3, 3') contains a composition $Hf_xSi_yO_z$ or $Zr_xSi_yO_z$ with an admixture of a silicon content (y) between 1 at.% and 3 at.% and an O content (z) between 65 at.% and 68 at.%.

**5.** The method according to claim 4, **characterized in that** production is performed by means of reactive co-magnetron sputtering of Hf or Zr and Si.

**6.** The method according to any one of claim 4 or 5, **characterized in that** the Si fraction is set so that the layer (3) has a minimum extinction with simultaneously low layer stress and high refractive index.

**7.** The use of an optical component (1) according to any one of claims 1 to 3, **characterized in that** the optical component (1) is used as laser mirror.

**8.** The use of an optical component (1) according to any one of claims 1 to 3, **characterized in that** the optical component (1) is used as cut-off filter.


**Revendications**

**1.** Composant optique (1), avec un substrat (2) et un revêtement (3) composé d'un oxyde à teneur en hafnium ou en zirconium ($Hf_xSi_yO_z$ ou $Zr_xSi_yO_z$) appliqué sur le substrat (2), ledit oxyde à teneur en hafnium ou en zirconium ($Hf_xSi_yO_z$ ou $Zr_xSi_yO_z$) contenant un mélange d'une fraction de silicium (y) entre 1 % at et 3 % at, et d'une fraction d'O (z) entre 65 % at et 68 % at, le substrat (2) étant en quartz.

**2.** Composant optique (1') selon la revendication 1, où le revêtement est réalisé comme système multicouche (5) comprenant au moins une couche (3') d'un oxyde à teneur en hafnium ou en zirconium ($Hf_xSi_yO_z$ ou $Zr_xSi_yO_z$), ledit oxyde à teneur en hafnium ou en zirconium ($Hf_xSi_yO_z$ ou $Zr_xSi_yO_z$) contenant un mélange d'une fraction de silicium (y) entre 1 % at et 3 % at, et d'une fraction d'O (z) entre 65 % at et 68 %.

**3.** Composant optique (1, 1') selon l'une des revendications précédentes, **caractérisé en ce que** la contrainte de la couche (3) ou du système multicouche est inférieure à 800 MPa, préférentiellement inférieure à 300 MPa ou inférieure à 100 MPa.

**4.** Procédé de fabrication d'un composant optique (1, 1') selon l'une des revendications 1 à 3, où le revêtement (3) d'oxyde à teneur en hafnium ou en zirconium est appliqué sur le substrat (2) au moyen d'une pulvérisation par magnétron, ledit revêtement (3, 3') contenant une composition de $Hf_xSi_yO_z$ ou de $Zr_xSi_yO_z$ avec un mélange d'une fraction de silicium (y) entre 1 % at et 3 % at, et d'une fraction d'O (z) entre 65 % at et 68 % at.

**5.** Procédé selon la revendication 4, **caractérisé en ce que** la fabrication est effectuée au moyen d'une co-pulvérisation par magnétron en condition réactive de Hf ou de Zr et Si.

**6.** Procédé selon la revendication 4 ou la revendication 5, **caractérisé en ce que** la fraction de Si est ajustée de sorte que la couche (3) présente une extinction minimale pour une faible contrainte de couche et un indice de réfraction élevé simultanément.

**7.** Utilisation d'un composant optique (1) selon l'une des revendications 1 à 3, **caractérisé en ce que** le composant optique (1) est utilisé comme miroir laser.

**8.** Utilisation d'un composant optique (1) selon l'une des revendications 1 à 3, **caractérisé en ce que** le composant optique (1) est utilisé comme filtre à arêtes.

Fig. 1a

Fig. 1b

Figur 2a

Figur 2b

Figur 3

Figur 4

Figur 5

Figur 6

Figur 7

Figur 8

EP 2 379 767 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 68928474 T2
- US 6413386 B1

- EP 2003013649 W